(19) Europäisches Patentamt

European Patent Office

Office européen des brevets

(11) Veröffentlichungsnummer **0 226 739**
**B1**

(12) **EUROPÄISCHE PATENTSCHRIFT**

(45) Veröffentlichungstag der Patentschrift: 19.12.90

(51) Int. Cl.⁵: **H 01 L 21/76,** H 01 L 21/20, H 01 L 21/203

(21) Anmeldenummer: 86114170.3

(22) Anmeldetag: 14.10.86

(54) Strukturierte Halbleiterkörper.

(30) Priorität: 20.12.85 DE 3545238

(43) Veröffentlichungstag der Anmeldung:
01.07.87 Patentblatt 87/27

(45) Bekanntmachung des Hinweises auf die
Patenterteilung:
19.12.90 Patentblatt 90/51

(84) Benannte Vertragsstaaten:
DE FR GB

(56) Entgegenhaltungen:
EP-A-0 097 789
DE-A-2 128 539

THIN SOLID FILMS, Band 106, Nr. 12, August
1983, Seiten 3-136, Elsevier Sequoia, NL; Y.
OTA: "Silicon molecular beam epitaxy"

(73) Patentinhaber: **Licentia Patent-Verwaltungs-GmbH**
**Theodor-Stern-Kai 1**
**D-6000 Frankfurt/Main 70 (DE)**

(73) Patentinhaber: **TELEFUNKEN electronic GmbH**
**Theresienstrasse 2**
**D-7100 Heilbronn (DE)**

(72) Erfinder: **Kasper, Erich, Dr. rer. nat.**
**Osterholzweg 16**
**D-7914 Pfaffenhofen (DE)**
Erfinder: **Herzog, Hans-Jöst, Dipl.-Phys.**
**Staufenbergstrasse 18**
**D-7910 Neu-Ulm (DE)**
Erfinder: **Wörner, Klaus**
**Wasserfallstrasse 12**
**D-7105 Leingarten (DE)**

(74) Vertreter: **Amersbach, Werner, Dipl.-Ing. et al**
**Licentia Patent-Verwaltungs-GmbH Theodor-Stern-Kai 1**
**D-6000 Frankfurt 70 (DE)**

**Beschreibung**

Die Erfindung betrifft einen strukturierten Halbleiterkörper nach dem Oberbegriff des Patentanspruchs 1.

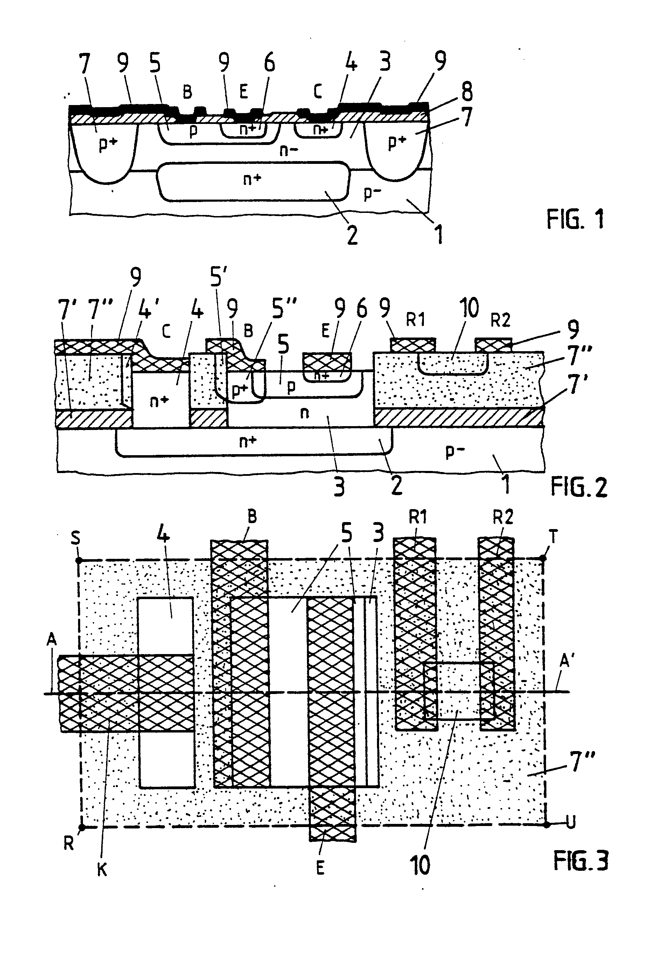

Die Erfindung ist insbesondere anwendbar zur Herstellung von Transistoren und/oder integrierten Schaltkreisen (IC's) auf der Grundlage eines Silizium (Si)-Substrates. Fig. 1 zeigt einen Querschnitt durch einen beispielhaft strukturierten Halbleiter, der insbesondere zur Herstellung bipolarer integrierter Schaltkreise verwendbar ist. Die angegebene Halbleiterstruktur ist herstellbar mit Hilfe von derzeit üblichen Verfahren, z.B. Maskierungsverfahren durch Lithographie, Oxidations-, Diffusions-, Implantations-, Epitaxie- sowie Metallisierungsverfahren.

Unter Verwendung derartiger Verfahren wird gemäß Fig. 1 zunächst auf ein beispielhaft $p^-$dotiertes Si-Substrat 1, z.B. eine Einkristall-Si-Scheibe mit einem Durchmesser von ungefähr 75 mm, einer Dicke von ungefähr 0,5 mm und einer (100)-Kristallorientierung, eine sogenannte vergrabene Halbeliterzone 2 ("buried layer") erzeugt. Anschließend werden die für einen Bipolar-Transistor erforderlichen Halbleiterbereiche erzeugt, bestehend aus einem n-dotierten Bereich 3, einem $n^+$-dotiertem Kollektorbereich 4, einem p-dotiertem Basisbereich 5 sowie einem darin befindlichen $n^+$-dotiertem Emitterbereich 6. Diese Halbleiterstruktur ist zur Vermeidung eines unerwünschten elektrischen Stromflusses begrenzt durch mindestens einen Sperrbereich 7, der in diesem Beispiel als $p^+$-dotierter Halbleiterbereich ausgebildet ist, der bis in das p-dotierte Substrat 1 reicht. Zur Vermeidung elektrischer Kurzschlüsse ist diese Halbleiterstruktur durch eine Oxidschicht 8, z.B. Siliziumdioxid, abgedeckt, in die Kontaktfenster eingeätzt sind. Nach dem Aufbringen einer strukturierten Metallschicht 9 in die Kontaktfenster entstehen der Basisanschluß B, der Emitteranschluß E und der Kollektoranschluß C.

Bei einem derart strukturierten Halbleiterkörper ist der Sperrbereich 7 in nachteiliger Weise lediglich durch kostenungünstige Isolationsdiffusions- und/oder Isolationsoxidationsvorgänge herstellbar.

Aus der DE 21 28 539 A1 ist eine integriete Schaltung gemäß dem Oberbefriff des Patentanspruchs 1 bekannt, bei welcher zur elektrischen Isolation eines Bauteils, beispielsweise eines Transistors, von anderen Bereichen der Schaltung das Bauteil in einem von polykristallinen Bereichen umgebenen Einkristall-Halbleiterbereich realisiert ist. Die einkristallinen und die polykristallinen Bereiche werden nach dem Verfahren der differentillen Epitaxie auf ein vorstrukturiertes Substrat gemeinsam aufgewachsen. Die Isolationswirkung entsteht durch eine pn-Sperrschicht an der Grenze zwischen polykristallinen und einkristallinen Bereichen. Die hierfür erforderliche unterschiedliche Dotierung in polykristallinen und einkristallinen Bereichnen wird erreicht, indem das zur Vorstrukturierung auf das Substrat aufgebrachte amorphe Material, z.B. $SiO_2$, hoch mit einer Verunreinigung dotiert wird, deren Leitfähigkeitstyp gleich dem des Substrats und verschieden von dem der nachfolgend aufgewachsenen Epitaxieschicht ist. Nach Aufwachsen der Epitaxieschicht wird durch Diffusion der Verunreinigung aus dem amorphen Material in die polykristallinen Bereiche bei hoher Temperatur eine Umdotierung der polykristallinen Bereiche vorgenommen, so daß die pn-Sperrschicht entsteht.

Zur Erzeugung der pn-Sperrschicht ist auch hierbei wieder ein Diffusionsvorgang erforderlich.

Zur Vermeidung der mit den hohen Temperaturen gebrächlicher CVD-Epitaxieverfahren verbundenen Nachteile ist in "Thin Solid Films", Band 106, No. 12, August 1983, S. 3-136 das Verfahren der Molekularstrahl-Epitaxie (MBE) angegeben. Bei MBE-Schichten, die auf einem vorstrukturierten Substrat nach dem Prinzip der differentiellen Epitaxie aufgewachsen werden, entstehen wiederum polykristalline und einkristallinen Bereiche, wobei die polykristallinen Bereiche hochohmig gegenüber den einkristallinen Bereichen sind. Für die Herstellung einer pn-Diode ist vorgeschlagen, eine von polykristallinen Silizium umgebene einkristalline Insel in der MBE-Schicht über eine auf dem polykristallinen Silizium geführte Metallleiterbahn zu kontaktieren. Als die zweite elektrische Zuleitung dient das stark dotierte Substrat und der pn-Übergang ist an der Grenzfläche zwischen Substrat und einkristallinem MBE-Bereich gebildet.

Der vorliegenden Erfindung liegt die Aufgabe zugrunde, einen gattungsgemäß strukturierten Halbleiterkörper anzugeben, der sich durch einfach herzustellende Trennbereiche zwischen elektrisch voneinander zu isolierenden Bereichen auszeichnet und zur Herstellung integrierter Schaltungen geeignet ist.

Dies Aufgabe wird gelöst durch die im kennzeichnenden Teil des Patentanspruchs 1 angegebenen Merkmale. Vorteilhafte Ausgestaltungen und Weiterbildungen sind den Unteransprüchen entnehmbar.

Die Erfindung beruht auf der nachfolgend erläuterten Anwendung der sogenannten differentiellen Epitaxie auf Si-haltigem Material, die z.B. aus der Zeitschrift Journal of the Electrochemical Society 132, Seite 2227 (1985), bekannt ist. Dabei wird in einer Ultrahochvakuumanlage (Vakuum kleiner $10^{-9}$ mbar) mit Hilfe des Silizium-Molekularstrahlepitaxieverfahrens (Si-MBE) eine Si-Schicht aufgewachsen auf einem Si-Substrat, auf dem einkristalline Si-Bereiche sowie Siliziumdioxid ($SiO_2$)-Bereiche benachbart sind. Durch Wahl der Temperatur des Si-Substrates sowie durch Wahl der Si-Wachsturmrate ist es gleichzeitig möglich, auf den einkristallinen Si-Bereichen einkristallines Si-Material aufzuwachsen während auf den $SiO_2$-Bereichen polykristallines Si-Material angeschieden wird, dessen spezifische Leitfähigkeit einige Größenordnungen kleiner ist als diejenige des einkristallinen Si-Materials. Es entsteht ein genau bestimmbarer Übergang zwischen polykristallinem und einkristallinem Si-Material.

Diese Eigenschaften sind nutzbar zur Herstellung der folgenden beispielhaft gewählten Halbleiterstruktur, die anhand einer schematischen Zeichnung näher erläutert wird. Es zeigen

Fig. 2 einen Querschnitt durch ein Ausführungsbeispiel, das demjenigen der Fig. 1 entspricht,

Fig. 3 eine Aufsicht auf das Ausführungsbeispiel gemäß Fig. 2.

In den Fig. 2 und 3 entsprechen die Bezugszeichen denjenigen der Fig. 1. In Fig. 3 ist mit den Bezugszeichen A, A' eine Linie bezeichnet, durch welche der Schnitt gemäß Fig. 2 gelegt ist.

In dem Ausführungsbeispiel gemäß den Fig. 2 und 3 wird in einem eingangs erwähnten p-dotierten Si-Substrat 1 zunächst die bereits erwähnte $n^+$-dotierte vergrabene Halbleiterzone 2 erzeugt. Anschließend werden das Si-Substrat 1 und die Halbleiterzone 2 ganzflächig durch eine ungefähr 0,2 µm dicke $SiO_2$-Oxidschicht 7' abgedeckt, die thermisch bei einer Temperatur von ungefähr 950°C hergestellt ist. Innerhalb des Bereiches der vergrabenen Halbleiterzone 2 werden nun zwei durch einen Abstand von ungefähr 3 µm benachbarte Fenster durch die Oxidschicht 7' geätzt. Dabei besitzt das Kollektor-Fenster eine Größe von 3 µm×50 µm und das Basis/Emitter-Fenster eine Größe von 6 µm×50 µm Anschließend wird ganzflächig das Si-MBE-Verfahren angewandt, wobei bei einer Substrattemperatur von 650°C durch Antimon (Sb) n-dotiertes Silizium abgeschieden wird. Dabei entstehen innerhalb der Fenster einkristalline Halbleitebereiche 3, 4 mit einer Schichtdiche von 0,6 µm und einer Sb-Konzentration von $1\times10^{16}/cm^3$ und außerhalb der Fenster, auf der Oxidschicht 7', polykristallines Silizium 7'' mit einer Schichtdicke von ebenfalls 0,6 µm. Aus den angegebenen Schichtdicken geht hervor, daß sich ein—und polykristalline Si-Bereiche in der dargestellten Weise berühren. Durch ein Dotierungsverfahren, z.B. Diffusions- oder Implantationsverfahren, ist est möglich, in dem Kollektor-Halbleiterbereich 4 eine $n^+$Phosphor (P)-Dotierung zu erzeugen mit einer Phosphor-Konzentration von $1\times10^{20}/cm^3$. Dabei ist es möglich, angrenzendes poly-Silizium 4' ebenfalls zu dotieren. In dem Basis/Emitter-Halbleiterbereich 3 wird ein durch Bor (B) p-dotierter Basis-Bereich 5 erzeugt mit einer Bor-Konzentration von $10^{18}/cm^3$ und einer Dicke von 0,3 µm. Daran angrenzend wird ein durch Bor $p^+$-dotierter Basiskontaktbereich 5'' erzeugt mit einer Bor-Konzentration von $10^{20}/cm^3$ und einer Schichtdicke von 0,4 µm. Dabei ist es möglich, angrenzendes poly-Silizium 5' ebenfalls zu dotieren. Innerhalb des Basis-Bereiches 5 wird nun durch eine $n^+$-Arsen (As)-Dotierung der Emitter-Bereich 6 erzeugt mit einer Arsen-Konzentration von $3\times10^{19}/cm^3$. Es sind einkristalline unterschiedlich dotierte Halbleiterbereich 3, 4 entstanden, die von Sperrbereichen 7 getrennt sind, die polykristallines Silizium 7'' enthalten. Kollektor-, Basis- und Emitterbereich sind durch metallische Leiterbahnen kontaktierbar, die z.B. aus einer Al/Si-Legierung bestehen, eine Dicke von ungefähr 1µm besitzen sowie eine Breite von ungefähr 3 µm (Fig. 3). Es entstehen die Kollektor-, Basis- und Emitteranschlüsse K, B, E.

Da das polykristalline Silizium 7'' eine spezifische elektrische Leitfähigkeit hat, die um einige Größenordnungen kleiner ist als diejenige der einkristallinen Si-Halbleiterbereiche, ist es möglich, in kostengünstiger Weise passive elektrische Widerstände zu integrieren. Dazu wird beispielsweise während der $n^+$-Dotierung des Emitters in dem polykristallinen Silizium 7'' ein Bereich, z.B. der Widerstandsbereich 10, so stark dotiert, daß dort eine nutzbare Leitfähigkeit von z.B. $10^{+2}$ $(Ohm\ cm)^{-1}$ entsteht. Über die geometrischen Ausmaße (Länge, Breite, Dicke) ist dann ein gewünschter Widerstandswert von z.B. 1 kOhm einstellbar. Der Widerstandsbereich 10 ist dann kontaktierbar durch die mit R1 und R2 bezeichneten Leiterbahnen. Auf diese Weise ist in kostengünstiger Weise beispielsweise eine Kombination aus mehreren Transistoren und einem passiven Widerstandsnetzwerk als integriertes Bauelement herstellbar.

Die Erfindung ist nicht auf die beschriebenen Ausführungsbeispiele beschränkt, sondern im Rahmen der vorliegenden Patentansprüche auf weitere anwendbar. Beispielsweise ist es möglich, das polykristalline Silizium 7'' außerhalb des mit RSTU bezeichneten Vierecks (Fig. 3) wegzuätzen und damit einen Übergang zu der Bipolar-Technologie nach dem Stand der Technik zu erzeugen.

**Patentansprüche**

1. Strukturierter Halbleiterkörper, bestehend aus mehreren einkristallinen Halbleiterbereichen und polykristallinen Sperrbereichen innerhalb einer mittels differentieller Epitaxie auf ein Substrat aufgewachsenen Schicht, wobei die einrkristallinen Halbleiterbereiche durch auf Bereiche einer Siliziumdioxidschicht aufgewachsene polykristalline Sperrbereiche begrenzt und gegeneinander isoliert sind, dadurch gekennzeichnet, daß die polykristallinen Sperrbereiche hochohmig gegenüber den einkristallinen Halbleiterbereichen sind und daß zur elektrischen Verbindung von durch einen polykristallinen Sperrbereich gegeneinander isolierten einkristallinen Halbleiterbereichen im Substrat eine unter dem polykristallinen Sperrbereich durchführende vergrabene Schicht vorgesehen ist.

2. Strukturierter Halbleiterkörper nach Anspruch 1, dadurch gekennzeichnet, daß in einem Sperrbereich (7) mindestens ein Widerstandsbereich (10) vorhanden ist.

3. Strukturierter Halbleiterkörper nach Anspruch 2, dadurch gekennzeichnet, daß der Widerstandsbereich durch eine Dotierung des polykristallinen Siliziums entstanden ist.

**Revendications**

1. Corps semi-conducteur structuré, qui consiste en plusieurs régions semi-conductrices monocristallines et en plusieurs régions d'état bloqué polycristallines à l'intérieur d'une couche formée sur un substrat par épitaxie différentielle, les régions semi-conductrices monocristallines étant limitées et isolées les unes par rapport aux autres par des régions d'état bloqué polycristallines formées sur des régions d'une couche de dioxyde de silicium, caractérisé en ce que les régions d'état bloqué polycristallines présentent une résistance élevée par rapport aux régions semi-conductrices monocristallines et en ce qi'il est prévu dans le substrat une couche enfouie qui s'étend sous la région d'état bloqué polycristalline pour la liaison électrique de régions semi-conductrices monocristallines isolées les unes par rapport aux autres par une région d'état bloqué polycristalline.

2. Corps semi-conducteur structuré selon la revendication 1, caractérisé en ce qu'il existe au moins une région de résistance (10) dans une région d'état bloqué (7).

3. Corps semi-conducteur structuré selon la revendication 2, caractérisé en ce que la région de résistance est formée par un dopage du silicium polycristallin.

**Claims**

1. Structured semiconductor body consisting of several monocrystalline semiconductor regions and polycrystalline barrier regions within a layer that has been grown on a substrate by means of differential epitaxy, wherein the monocrystalline semiconductor regions are bounded and mutually insulated by polycrystalline barrier regions that have been grown on regions of a silicon dioxide layer, characterised thereby, that the polycrystalline barrier regions are of high resistance compared with the monocrystalline semiconductor regions and that a buried layer, which leads through below a polycrystalline barrier region, is provided in the substrate for the electrical connection of monocrystalline semiconductor regions insulated one from the other by the polycrystalline barrier region.

2. Structured semiconductor body according to claim 1, characterised thereby, that at least one resistance region (10) is present in a barrier region (7).

3. Structured semiconductor body according to claim 2, characterised thereby, that the resistance region has arisen through a doping of the polycrystalline silicon.

EP 0 226 739 B1

FIG. 1

FIG. 2

FIG. 3

1